# EUROPEAN PATENT SPECIFICATION

(11) **EP 2 380 418 B1**
(45) Date of publication and mention of the grant of the patent: **05.03.2014**
(21) Application number: 09775342.0
(22) Date of filing: 18.12.2009
(51) Int. Cl.: H05K 13/00, H05K 13/04

(54) **METHOD AND DEVICE FOR POSITIONING A SUBSTRATE AND A COMPONENT FOR MOUNTING THEREON RELATIVE TO EACH OTHER**
VERFAHREN UND EINRICHTUNG ZUM POSITIONIEREN EINES SUBSTRATS UND EINER KOMPONENTE ZUR ANBRINGUNG DARAUF RELATIV ZUEINANDER
PROCÉDÉ ET DISPOSITIF POUR POSITIONNER L'UN PAR RAPPORT À L'AUTRE UN SUBSTRAT ET UN COMPOSANT À MONTER SUR LE SUBSTRAT

(30) Priority: 19.12.2008 NL 2002346
(43) Date of publication of application: 26.10.2011
(73) Proprietor: Van Den Brink Consultancy, 3533 HA Utrecht (NL)
(72) Inventor: VAN DEN BRINK, Hans, Gerard, NL-3533 HA Utrecht (NL)
(74) Representative: van Oeffelt, Abraham
(86) International application number: PCT/NL2009/050775
(87) International publication number: WO 2010/077134

(56) References cited:
- EP-B- 0 694 248
- DD-A1- 242 320
- DE-A1- 4 119 401

## Description

The present invention relates to a method and device for positioning a substrate, such as a printed circuit board for electronic components, and a component for mounting thereon relative to each other. Such devices are per se known and are applied for the manual manufacture or repair of electronic circuits. An object of the invention is to position the component here relative to the substrate such that associated electrical contacts of the respective component and substrate can be mutually connected, for instance by means of soldering, bonding or glueing.

The European patent EP 0 694 248 describes a device intended for the above stated purpose, making use of a dividing mirror which is vapour-deposited onto a mirror carrier and sandwiched between an optically identical compensation plate. Optically, the spaces in front of and behind the dividing mirror are hereby the mirror image of each other. Essential in this invention is the simultaneous observation of the underside of the object for placing and the intended destination of the object. The trend tends however towards increasingly smaller tolerances, and the requirements set for placing accuracy are approaching the limit of the achievable. The known device therefore has several drawbacks. The thickness of a component, which is generally unknown before placing, causes uncertainty regarding the exact position of the surface of the component to be mounted on the substrate, with a shifted image created as a result of parallax. It is also only possible with this invention to successively perform various operations necessary for the purpose of positioning the component, this resulting in a time-consuming method. DD 242 320 shows a device where the component does not lie in the plane of the mirror.

It is an object of the present invention to provide a method and device which at least partially obviate the above stated drawbacks, or to provide a practical alternative. The invention provides for this purpose a device according to claim 1 and a method according to claim 14.

The device according to the present invention comprises a mirror, with a semitransparent plane of the mirror, a substrate holder which is adapted to hold a surface of the substrate on which the component has to be mounted in a plane at a first angle relative to the plane of the mirror, a component holder adapted to determine an aligning position, wherein the surface of the component to be mounted on the substrate is situated in a plane at a second angle, equal to the first but in opposite direction thereto, relative to the plane of the mirror, wherein the intersecting line of the surface of the component and the surface of the substrate with the plane of the mirror coincide, and a mounting position, wherein the surface of the component to be mounted on the substrate lies on the surface of the substrate on which the component has to be mounted, and aligning means for mutually aligning the component and the substrate.

Because the component holder is adapted to determine an aligning position in which the surface of the component to be mounted on the substrate is situated in a plane at a second angle, equal to the first but in opposite direction thereto, relative to the plane of the mirror, as the substrate, for an observer looking at the mirror via per se known optics their images lie in the same plane. Relative to prior art devices, in which no explicit provisions are made precisely for the purpose of positioning the surfaces to be mounted on each other at equal but opposite angles relative to the plane of the mirror, the.present invention provides the advantage that it provides a correct positioning irrespective of the thickness of a component. Thickness is here understood to mean the dimension of the component in a direction perpendicularly of the surface of the component to be mounted on the substrate. This thickness varies between the usual components.

In a favourable embodiment the component holder is adapted to determine a pick-up position for the component, wherein a surface of the component to be mounted on the substrate lies in the plane of the mirror.

Such a position for the component provides a reference for bringing the component into the aligning position. By placing the surface of the component to be mounted on the substrate in the plane of the mirror the component can be picked up by the component holder at an exactly known position relative to the plane of the mirror, and so also carried to an exactly known position by means of a known displacement in order to be aligned. Relative to the prior art the present invention here also provides the advantage that the plane of the mirror need not be displaced between bringing the component into the pick-up position and bringing the component into the aligning position. The device according to the present invention is hereby also more accurate than the known device, and the diverse processing steps for components to be placed successively on the same or different printed circuit boards can take place at least partially simultaneously.

The displacing of the component can for instance be made possible by connecting the component holder to an arm which is rotatable around the intersecting line of the plane of the substrate on which the component has to be mounted and the plane of the mirror, so that the component holder is displaceable along at least a part of a circle. Since the surface of the component to be mounted on the substrate is situated in the plane of the mirror in the pick-up position, the plane in which this surface is situated after a rotation around the intersecting line likewise has the same intersecting line with the plane of the mirror.

When the component holder is connected to the arm for translation in a direction parallel to the tangent at its momentary position on the circle, the component holder can be displaced by means of translation relative to the arm, when the arm is situated in a predetermined position, such that the holder lies precisely against the component, in order to then pick it up.

The device can here be provided with at least a first limiter, such as a stop, for limiting the rotation of the arm at a position in which a line from the rotation point to the connection with the pick-up means runs substantially parallel to the plane of the mirror. This position of the arm is particularly suitable for picking up the component since, when the arm rotates around this point, the displacement of the component holder in the direction of the plane of the mirror is minimal, so that the component is not shifted, or hardly so, when it is picked up. Around this point the displacement of the component holder is substantially in the direction perpendicularly of the plane of the mirror, so that from this point the component holder can be placed precisely against the component by means of translation when the arm has been or is placed against the first limiter.

The device can also be provided with a second limiter for limiting the rotation of the arm to an angle the size of the first angle (the angle between a surface of the substrate on which the component has to be mounted and the plane of the mirror) relative to the position defined by the first limiter. In this way a maximum rotation, or stroke of the arm and the component holder connected thereto, can be fixed at the value of the first angle.

The component holder is preferably adapted here to pick up the component from the plane of the mirror when the arm is situated in the position determined by the first limiter. When the arm is then displaced up to the second limiter, the component comes to lie exactly in the aligning position. In a favourable embodiment this arm is provided with balancing means, such as a counterweight, whereby it becomes possible to displace the component in highly controlled manner between the various positions and particularly to allow it to come to rest gently on the substrate.

In order to enable placing of the component, the component holder or the arm in the pick-up position, the aligning position and the mounting position, it is advantageous that the device be provided with a displaceable mirror holder with which the mirror can be displaced from at least a position between the component holder and the substrate holder, so that the mirror can be used to align the components, and at least a position in which the component holder can be displaced from the aligning position to the mounting position.

The mirror holder can be adapted here to displace the mirror only within the plane of the mirror. Such a displacement requires few degrees of freedom of movement, and for this purpose results in a construction which is not susceptible, or hardly so, to wear and inaccuracy resulting therefrom. A very simple and robust construction can be obtained by disposing the mirror holder for rotation around an axis perpendicularly of the plane of the mirror.

The mirror holder can here further serve to determine the pick-up position. The holder then comprises for this purpose a surface on which the component can be placed, wherein this surface coincides with the plane of the mirror. For this purpose the mirror can comprise an assembly of two parts, between which the plane of the mirror is situated. The mirror is manufactured for this purpose from for instance a first part consisting of a plate-like substrate on which a mirror layer is arranged and against which a second, likewise plate-like part is arranged on the mirror side. The dimensions of one of the two parts can here be greater, at least in a direction in the plane of the mirror, than the dimensions of the second part in the same direction, so that the mirror can be placed in a recess of the mirror holder which corresponds substantially to the dimension of the part with the smaller dimension in said direction. The mirror then lies with the plane of the mirror precisely against the plane of the mirror holder in which the recess is situated, so that this plane corresponds with the plane of the mirror and can serve to also place the component on the plane of the mirror.

For alignment of the component relative to the substrate either the component or the substrate can be translated or rotated. For this purpose the device comprises either means for translating the substrate parallel to the surface of the substrate or means for translating the component parallel to the surface of the component; and either means for rotating the substrate about a rotation axis perpendicularly of the surface of the substrate or means for translating the component about a rotation axis perpendicularly of the surface of the component. If desired, both the substrate and the component can each be arranged for both translation and rotation.

For the purpose of providing a good view during alignment, lighting can be provided for the substrate and lighting for the component Translation and rotation of the component or the substrate are in this way possible during the alignment until the two illuminated images overlap each other. The lighting for the component and the lighting for the substrate can here have different colours, and/or for instance be switched on and off repeatedly.

The invention will now be elucidated on the basis of the following non-limitative figures, in which like components are designated with like reference numerals.
Figures 1a-1d show a device according to the present invention in a pick-up position;
Figures 2a-2d show a device according to the present invention in an aligning position; and
Figures 3a-3c show a device according to the present invention in a mounting position.

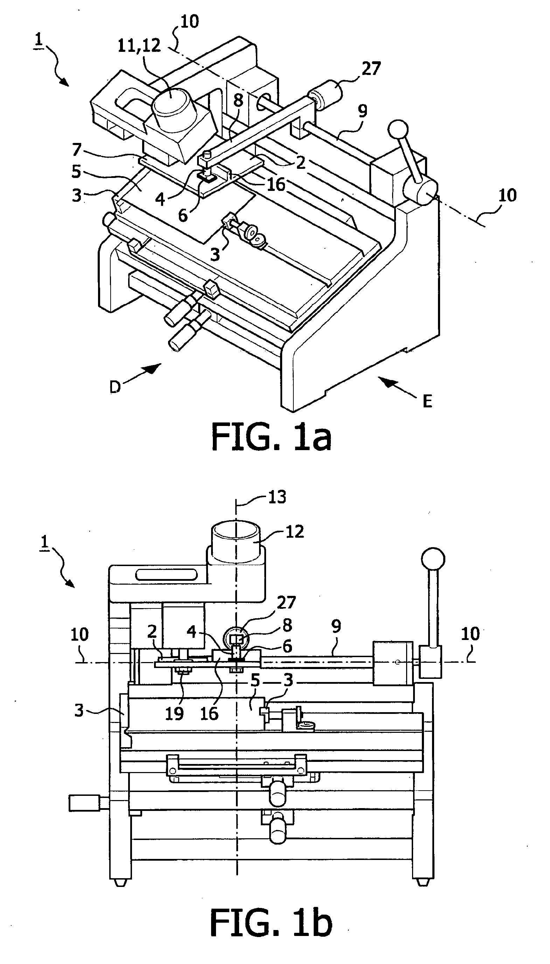

Figure 1a shows a perspective view of a device 1 according to the present invention, comprising a mirror 2 with a semitransparent plane of the mirror, a substrate holder 3 and a component holder 4. A substrate 5 is fixed in substrate holder 3 and a component 6, which also rests on mirror holder 7, is fixed to component holder 4. Mirror holder 7 has an upper plane coinciding with the plane of the mirror of mirror 2. Component holder 4 is mounted for rotation around shaft 9 via an arm 8, which shaft is coaxial with the intersecting line 10 of the plane of the mirror of mirror 2 and the surface of substrate 5 on which component 6 has to be mounted. Component 6 is placed in the pick-up position, wherein the surface of component 6 to be mounted on substrate 5 is situated in the plane of the mirror.

Figure 1b shows device 1 of figure 1a as seen from the direction indicated with arrow D in figure 1a. It can be seen that a user of device 1 looking through viewer 12 is viewing at the position of component 6 on substrate holder 3, and does not see mirror 2 in the pick-up position. Instead of a viewer through which the user looks directly, it is also possible to make use of a camera provided with a display unit, such as a monitor, optionally placed at a distance.

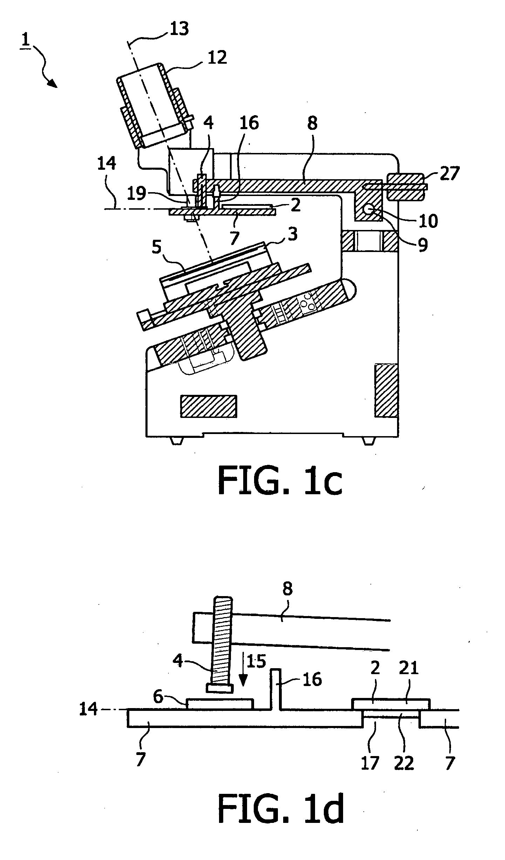

Figure 1c shows device 1 of figure 1a as seen from the direction of arrow E. Line 13 indicates how a user of the device can look at the component via viewer 12. Also indicated is the plane of mirror 14 of mirror 2, which corresponds with the upper surface of mirror holder 7.

Figures 1a-1c show bow arm 8 rests on stop 16, wherein component holder 4 rests precisely on the component. Figure 1d shows a situation prior thereto, in which arm 8 does not yet quite rest on stop 16. When arm 8 is displaced from the situation shown in figure 1d in the direction of arrow 15, component holder 4 comes into contact with component 6 at a given moment before arm 8 is limited in its rotation by stop 16. Component holder 4 is for this purpose connected for translation to the arm. When the arm is now moved further until it lies against stop 16, the arm displaces relative to component holder 4, which remains lying against the component. As soon as the situation is reached as shown in figures 1a-1c, the arm lies at a predetermined position while the surface of the component to be mounted on the substrate lies precisely in the plane of mirror 14 of mirror 2. This plane of mirror 14 is formed by the upper side of mirror holder 7. That this upper side corresponds with the plane of mirror 14 is brought about in that mirror 2 is formed by two mirror parts, the upper of which is greater than the lower, and between which the plane of the mirror is situated. Since upper mirror part 21 is larger than lower mirror part 22, the dimensions of which correspond with those of a recess 17 in mirror holder 7, upper mirror part 21 of mirror 2 rests precisely on the upper side of mirror holder 7. Holding of the component by component holder 4 can for instance take place in that the component holder is provided with suction means and can apply a vacuum. The translation of the component holder relative to the arm can likewise be blocked or released by means of such provisions. In order to allow the displacement of the arm and the component to take place in as controlled a manner as possible, arm 8 is provided on the side remote from component holder 4 with a counterweight 27, which is preferably displaceable relative to rotation axis 10 so as to enable control of the moment exerted by counterweight 27.

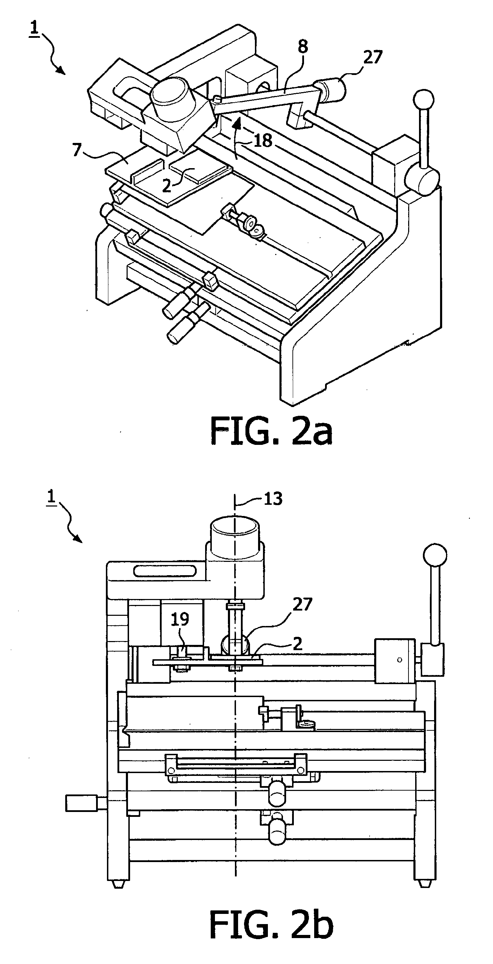

Figure 2a shows device 1 of the foregoing figures, wherein arm 8 is rotated with the component holder and the component through an angle 18. Angle 18 is equal to the angle between the plane of the mirror and the surface of substrate 5 on which the component has to be placed. The component is hereby placed in the aligning position. Mirror holder 7 is also rotated about shaft 19, whereby a user of the device looking through viewer 12 in direction 13 is now looking at the mirror, as can be seen in figure 2b.

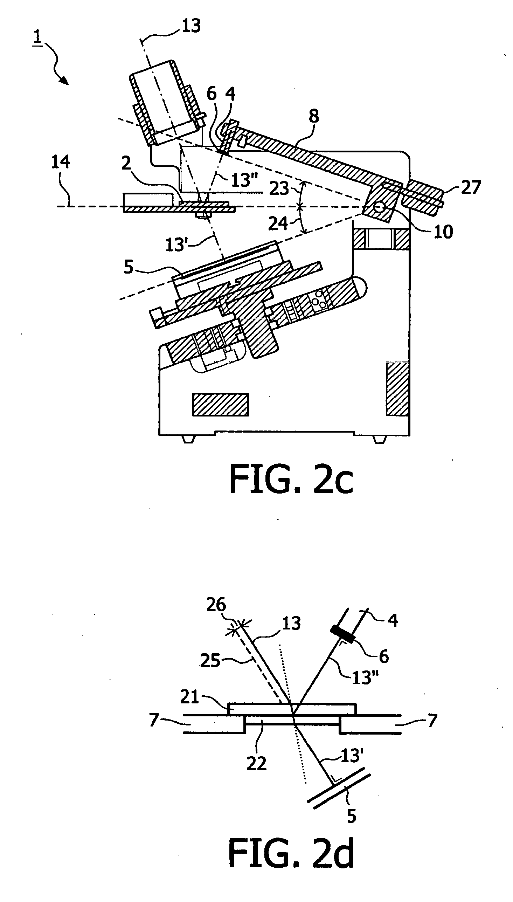

Figure 2c shows that the surface of the substrate on which the component has to be mounted and the surface of the component to be mounted on the substrate are situated in a plane at an equal but opposite angle relative to the plane of mirror 14, wherein the intersecting line 10 of the surface of the component and the surface of the substrate with the plane of mirror 14 coincide.

A user of device 1 who is looking in direction 13 now sees an image of substrate 5, because mirror 2 transmits light in direction 13', as well as an image of component 6 because the mirror reflects light in direction 13". Figure 2d shows this in more detail. Shown are an incident light beam 13 and a transmitted light beam 13' as well as a reflected light beam 13". Mirror 2 is preferably constructed from a first part 21 and a second part 22, which are manufactured from optical glass which is cut and polished in the same operation so that they have exactly the same thickness. In this way the inevitable parallax 26 (the distance between light beam 13 and the line 25 coinciding with light beam 13') resulting from the refraction by mirror 2 becomes the same for the image of the component and the image of the substrate irrespective of the angle at which viewing takes place through viewer 12. This increases still further the possibility of accurate positioning of a component on a substrate using the present invention.

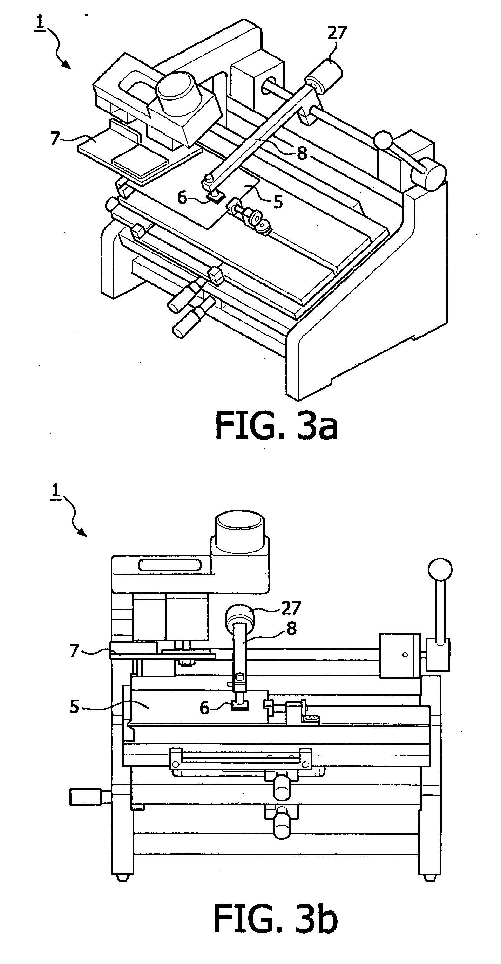

Figure 3a shows device 1 of figures 1 and 2, wherein the surface of component 6 to be mounted on substrate 5 lies on the surface of the substrate 5 on which component 6 has to be mounted

To enable movement of component 6 into this position, mirror holder 7 is once again rotated about rotation shaft 19 so that mirror 2 and the mirror holder are situated outside the circular path described by component holder 4 when arm 8 is rotated about shaft 9, as shown in figure 3b. In this position component 6 can be mounted on substrate 5.

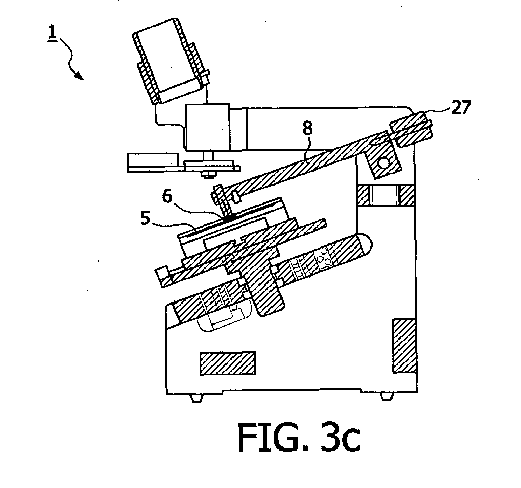

In the shown embodiment the component and the substrate lie at an angle to the horizontal in the mounting position, as can be seen in figure 3c. Configurations can however be envisaged - for instance when the soldering technique used requires this - in which the device is tilted such that the mounting position has a horizontal position of the substrate and the component.

Such configurations and other variants within the inventive concept all fall within the scope of protection of the present application, as set forth in the following claims.

## Claims

1. Device for positioning a substrate (5) and a component (6) for mounting thereon relative to each other, comprising:
- a mirror (2), with a semitransparent plane of the mirror;
- a substrate holder (3) adapted to hold a surface of the substrate (5) on which the component (6) has to be mounted in a plane at a first angle relative to the plane of the mirror (2);
- a component holder (4) adapted to determine:
○ an aligning position, wherein the surface of the component (6) to be mounted on the substrate (5) is situated in a plane at a second angle, equal to the first but in opposite direction thereto, relative to the plane of the mirror (2), wherein the intersecting line of the surface of the component (6) and the surface of the substrate with the plane of the mirror (2) coincide; and
○ a mounting position, wherein the surface of the component (6) to be mounted on the substrate (5) lies on the surface of the substrate (5) on which the component (6) has to be mounted,
- aligning means for mutually aligning the component and the substrate **characterised in that**
the component holder (4) is adapted to determine:
o a pick-up position for the component (6), wherein a surface of the component to be mounted on the substrate (5) lies in the plane of the mirror (2).

2. Device as claimed in claim 1, wherein the component holder (4) is connected to an arm (8) which is rotatable around the intersecting line so that the component holder (4) is displaceable along at least a part of a circle.

3. Device as claimed in claim 2, wherein the component holder (4) is connected to the arm (8) for translation in a direction parallel to the tangent at its momentary position on the circle.

4. Device as claimed in claim 3, provided with at least a first limiter, such as a stop (16), for limiting the rotation of the arm (8) at a position in which a line from the rotation point to the connection with the pick-up means runs substantially parallel to the plane of the mirror (2).

5. Device as claimed in claim 4, provided with a second limiter for limiting the rotation of the arm to an angle the size of the first angle relative to the position defined by the first limiter (16).

6. Device as claimed in any of the claims 2-5, wherein the component holder (4) is adapted to pick up the component when the arm (8) is situated in the position determined by the first limiter (16).

7. Device as claimed in any of the foregoing claims, provided with a displaceable mirror holder (7) with which the mirror (2) can be displaced from a position between the component holder (4) and the substrate holder (3), and a position in which the component holder (4) can be displaced from the aligning position to the mounting position.

8. Device as claimed in claim 7, wherein the mirror holder is adapted to displace the mirror (2) within the plane of the mirror.

9. Device as claimed in claim 7 or 8, wherein the mirror holder (7) is also adapted to determine the pick-up position.

10. Device as claimed in any of the foregoing claims, wherein the mirror (2) comprises an assembly of two optically identical substrate layers between which the plane of the mirror is situated, and wherein the dimensions of the first layer are greater, at least in a direction in the plane of the mirror, than the dimensions of the second layer.

11. Device as claimed in any of the foregoing claims, wherein the aligning means comprise:
at least one of
a. means for translating the substrate parallel to the surface of the substrate (5),
b. means for translating the component (6) parallel to the surface of the component; and
at least one of
c. means for rotating the substrate (5) about a rotation axis perpendicularly of the surface of the substrate, and
d. means for translating the component (6) about a rotation axis perpendicularly of the surface of the component.

12. Device as claimed in any of the foregoing claims, wherein a lighting (13) is provided in a first colour for the substrate (5) and a lighting is provided in a second colour for the component (6).

13. Device as claimed in any of the claims 2-12, wherein the arm (8) is provided with a balancing means, such as a counterweight (27), for controlling the force with which the component is displaced between different positions.

14. Method for positioning a substrate (5) and a component (6) for mounting thereon relative to each other, comprising of:
- holding a surface of the substrate (5) on which the component (6) has to be mounted in a plane at a first angle relative to the plane of the mirror (2),
- placing the component (6) in an aligning position, wherein the surface of the component to be mounted on the substrate (5) is situated in a plane at a second angle, equal to the first but in opposite direction thereto, relative to the plane of the mirror (2), wherein the intersecting line of the surface of the component (6) and the surface of the substrate (5) with the plane of the mirror (2) coincide;
- mutually aligning the component (6) and the substrate (5); and
- placing the component (6) in a mounting position, wherein the surface of the component to be mounted on the substrate lies on the surface of the substrate (5) on which the component has to be mounted,
**characterised by**
- determining a pick-up position for the component (6), wherein a surface of the component to be mounted on the substrate (5) lies in the plane of the mirror (2).

15. Method as claimed in claim 14, comprising at least one of:
- translating the substrate (5) parallel to the surface of the substrate,
- translating the component (6) parallel to the surface of the component; and at least one of
- rotating the substrate (5) about a rotation axis perpendicularly of the surface of the substrate, and
- translating the component (6) about a rotation axis perpendicularly of the surface of the component.

16. Mirror (2), for use in a device or method according to any of the preceding claims, comprising an assembly of two optically identical substrate layers (22,21) between which the plane of the mirror is situated, and wherein the dimensions of the first layer (22) are greater, at least in a direction in the plane of the mirror, than the dimensions of the second layer (21).

## Patentansprüche

1. Vorrichtung zum Positionieren eines Substrats (5) und einer Komponente (6) zum Montieren relativ zueinander auf demselben, umfassend:
- einen Spiegel (2) mit einer halbdurchlässigen Ebene des Spiegels;
- einen Substrathalter (3), der zum Halten einer Fläche des Substrats (5) ausgelegt ist, auf der die Komponente (6) in einer Ebene unter einem ersten Winkel relativ zur Ebene des Spiegels (2) montiert werden muss,
- einen Komponentenhalter (4), der zum Bestimmen von Folgendem ausgelegt ist:
○ eine Fluchtungsposition, wobei die Fläche der Komponente (6), die auf dem Substrat (5) montiert werden soll, sich in einer Ebene unter einem zweiten Winkel, der gleich dem ersten ist, aber die entgegengesetzte Richtung dazu hat, relativ zur Ebene des Spiegels (2) befindet, wobei die Schnittlinie der Fläche der Komponente (6) und der Fläche des Substrats (5) mit der Ebene des Spiegels (2) zusammenfallen; und
○ eine Montageposition, wobei die Fläche der Komponente (6), die auf dem Substrat (5) montiert werden soll, auf der Fläche des Substrats (5) liegt, auf der die Komponente (6) montiert werden muss,
- Fluchtungsmittel für wechselseitiges Fluchten der Komponente und des Substrats,
**dadurch gekennzeichnet, dass**
der Komponentenhalter (4) zum Bestimmen von Folgendem ausgelegt ist:
○ eine Aufnahmeposition für die Komponente (6), wobei eine Fläche der Komponente, die auf dem Substrat (5) montiert werden soll, in der Ebene des Spiegels (2) liegt.

2. Vorrichtung nach Anspruch 1, wobei der Komponentenhalter (4) mit einem Arm (8) verbunden ist, der um die Schnittlinie drehbar ist, so dass der Komponentenhalter (4) zumindest auf einem Teil eines Kreises verschiebbar ist.

3. Vorrichtung nach Anspruch 2, wobei der Komponentenhalter (4) mit dem Arm (8) zur Verschiebung in einer Richtung parallel zur Tangente an seiner momentanen Position auf dem Kreis verbunden ist.

4. Vorrichtung nach Anspruch 3, die zumindest mit einem ersten Begrenzer, wie zum Beispiel einem Anschlag (16), zum Begrenzen der Rotation des Arms (8) an einer Position versehen ist, an der eine Gerade vom Drehpunkt zur Verbindung mit dem Aufnahmemittel im Wesentlichen parallel zur Ebene des Spiegels (8) verläuft.

5. Vorrichtung nach Anspruch 4, die mit einem zweiten Begrenzer zum Begrenzen der Rotation des Arms bis zu einem Winkel von der Größe des ersten Winkels relativ zu der Position versehen ist, die durch den ersten Begrenzer (16) definiert ist.

6. Vorrichtung nach einem der Ansprüche 2-5, wobei der Komponentenhalter (4) zum Aufnehmen der Komponente ausgelegt ist, wenn der Arm (8) sich in der Position befindet, die durch den ersten Begrenzer (16) bestimmt wird.

7. Vorrichtung nach einem der vorherigen Ansprüche, die mit einem verschiebbaren Spiegelhalter (7) versehen ist, mit dem der Spiegel (2) von einer Position zwischen dem Komponentenhalter (4) und dem Substrathalter (3) verschoben werden kann, und von einer Position, in der der Komponentenhalter (4) aus der Fluchtungsposition in die Montageposition verschoben werden kann.

8. Vorrichtung nach Anspruch 7, wobei der Spiegelhalter zum Verschieben des Spiegels (2) innerhalb der Ebene des Spiegels ausgelegt ist.

9. Vorrichtung nach Anspruch 7 oder 8, wobei der Spiegelhalter (7) auch zum Bestimmen der Aufnahmeposition ausgelegt ist.

10. Vorrichtung nach einem der vorherigen Ansprüche, wobei der Spiegel (2) eine Baugruppe von zwei optisch identischen Substratschichten umfasst, zwischen denen sich die Spiegelebene befindet, und wobei die Abmessungen der ersten Schicht größer als die Abmessungen der zweiten Schicht sind, zumindest in einer Richtung in der Spiegelebene.

11. Vorrichtung nach einem der vorherigen Ansprüche, wobei das Fluchtungsmittel Folgendes umfasst:
mindestens ein Element aus
a. Mittel zum Verschieben des Substrats parallel zur Fläche des Substrats (5),
b. Mittel zum Verschieben der Komponente (6) parallel zur Fläche der Komponente;
und
mindestens ein Element aus
c. Mittel zum Drehen des Substrats (5) um eine Rotationsachse senkrecht zur Fläche des Substrats, und
d. Mittel zum Verschieben der Komponente (6) um eine Rotationsachse senkrecht zur Fläche der Komponente.

12. Vorrichtung nach einem der vorherigen Ansprüche, wobei eine Beleuchtung (13) in einer ersten Farbe für das Substrat (5) vorgesehen ist und eine Beleuchtung in einer zweiten Farbe für die Komponente (6) vorgesehen ist.

13. Vorrichtung nach einem der Ansprüche 2-12, wobei der Arm (8) mit einem Ausgleichsmittel versehen ist, wie zum Beispiel einem Gegengewicht (27), das zum Steuern der Kraft dient, mit der die Komponente zwischen verschiedenen Positionen verschoben wird.

14. Verfahren zum Positionieren eines Substrats (5) und einer Komponente (6) zum Montieren relativ zueinander, umfassend:
- Halten einer Fläche des Substrats (5), auf dem die Komponente (6) in einer Ebene unter einem ersten Winkel relativ zur Ebene des Spiegels (2) montiert werden muss,
- Platzieren der Komponente (6) in einer Fluchtungsposition, wobei die Fläche der Komponente, die auf dem Substrat (5) montiert werden soll, sich in einer Ebene unter einem zweiten Winkel, der gleich dem ersten ist, aber die entgegengesetzte Richtung dazu hat, relativ zur Ebene des Spiegels (2) befindet, wobei die Schnittlinie der Fläche der Komponente (6) und der Fläche des Substrats (5) mit der Ebene des Spiegels (2) zusammenfallen;
- wechselseitiges Fluchten der Komponente (6) und des Substrats (5); und
- Platzieren der Komponente (6) in einer Montageposition, wobei die Fläche der Komponente, die auf dem Substrat montiert werden soll, auf der Fläche des Substrats (5) liegt, auf der die Komponente montiert werden muss, **gekennzeichnet durch**
- Bestimmen einer Aufnahmeposition für die Komponente (6), wobei eine Fläche der Komponente, die auf dem Substrat (5) montiert werden soll, in der Ebene des Spiegels (2) liegt.

15. Verfahren nach Anspruch 14, das mindestens eins aus Folgendem umfasst:
- Verschieben des Substrats (5) parallel zur Fläche des Substrats,
- Verschieben der Komponente (6) parallel zur Fläche der Komponente; und mindestens eins aus Folgendem:
- Drehen des Substrats (5) um eine Rotationsachse senkrecht zur Fläche des Substrats, und
- Verschieben der Komponente (6) um eine Rotationsachse senkrecht zur Fläche der Komponente.

16. Spiegel (2), zur Verwendung in einer Vorrichtung oder einem Verfahren nach einem der vorherigen Ansprüche, der eine Baugruppe von zwei optisch identischen Substratschichten (22, 21) umfasst, zwischen denen sich die Spiegelebene befindet, und wobei die Abmessungen der ersten Schicht (22) größer als die Abmessungen der zweiten Schicht (21) sind, zumindest in einer Richtung in der Spiegelebene.

## Revendications

1. Dispositif pour positionner un substrat (5) et un composant (6) à monter sur celui-ci l'un par rapport à l'autre, comprenant :
- un miroir (2) avec un plan de miroir semi-transparent ;
- un support de substrat (3) conçu pour supporter une surface du substrat (5) sur laquelle le composant (6) doit être monté dans un plan à un premier angle par rapport au plan du miroir (2) ;
- un support de composant (4) conçu pour déterminer :
- une position d'alignement, la surface du composant (6) à monter sur le substrat (5) se situant dans un plan à un second angle égal au premier, mais dans la direction opposée à celui-ci, par rapport au plan du miroir (2), la ligne d'intersection de la surface du composant (6) et de la surface du substrat (5) avec le plan du miroir (2) étant coïncidente ; et
- une position de montage, la surface du composant (6) à monter sur le substrat (5) se situant sur la surface du substrat (5) sur laquelle le composant (6) doit être monté ;
- un moyen d'alignement afin d'aligner mutuellement le composant et le substrat ;
- **caractérisé en ce que** :
- le support de composant (4) est conçu pour déterminer une position de prise pour le composant (6), une surface du composant à monter sur le substrat (5) se situant dans le plan du miroir (2).

2. Dispositif selon la revendication 1, dans lequel le support de composant (4) est connecté à un bras (8) qui peut tourner autour de la ligne d'intersection de sorte que le support de composant (4) peut être déplacé le long d'une partie au moins d'un cercle.

3. Dispositif selon la revendication 2, dans lequel le support de composant (4) est connecté au bras (8) afin d'effectuer une translation dans une direction parallèle à la tangente en sa position momentanée sur le cercle.

4. Dispositif selon la revendication 3, comprenant au moins un premier limiteur, comme un arrêtoir (16), afin de limiter la rotation du bras (8) en une position où une ligne allant du point de rotation à la connexion avec le moyen de prise est essentiellement parallèle au plan du miroir (2).

5. Dispositif selon la revendication 4, comprenant un second limiteur afin de limiter la rotation du bras à un angle de la taille du premier angle par rapport à la position définie par le premier limiteur (16).

6. Dispositif selon l'une quelconque des revendications 2 à 5, dans lequel le support de composant (4) est conçu pour prendre le composant lorsque le bras (8) se situe dans la position délimitée par le premier limiteur (16).

7. Dispositif selon l'une quelconque des revendications précédentes, comprenant un support de miroir déplaçable (7) avec lequel le miroir (2) peut être déplacé d'une position entre le support de composant (4) et le support de substrat (3), en une position dans laquelle le support de composant (4) peut être déplacé de la position d'alignement vers la position de montage.

8. Dispositif selon la revendication 7, dans lequel le support de miroir est conçu pour déplacer le miroir (2) dans le plan du miroir.

9. Dispositif selon les revendications 7 ou 8, dans lequel le support de miroir (7) est également conçu pour déterminer la position de prise.

10. Dispositif selon l'une quelconque des revendications précédentes, dans lequel le miroir (2) comprend un système de deux couches de substrat optiquement identiques entre lesquelles se situe le plan du miroir, et dans lequel les dimensions de la première couche sont plus importantes, au moins dans une direction dans le plan du miroir, que les dimensions de la seconde couche.

11. Dispositif selon l'une quelconque des revendications précédentes, dans lequel le moyen d'alignement comprend :
- l'un au moins de :
a. un moyen pour réaliser une translation du substrat parallèlement à la surface du substrat (5) ;
b. un moyen pour réaliser une translation du composant (6) parallèlement à la surface du composant ; et
- l'un au moins de :
c. un moyen pour faire tourner le substrat (5) autour d'un axe de rotation perpendiculairement à la surface du substrat ; et
d. un moyen pour réaliser une translation du composant (6) autour d'un axe de rotation perpendiculairement à la surface du composant.

12. Dispositif selon l'une quelconque des revendications précédentes, dans lequel un éclairage (13) ayant une première couleur est utilisé pour le substrat (5), tandis qu'un éclairage ayant une seconde couleur est utilisé pour le composant (6).

13. Dispositif selon l'une quelconque des revendications 2 à 12, dans lequel le bras (8) comprend un moyen d'équilibrage, comme un contrepoids (27), afin de commander la force selon laquelle le composant est déplacé entre différentes positions.

14. Procédé de positionnement d'un substrat (5) et d'un composant (6) à monter sur celui-ci l'un par rapport à l'autre, consistant à :
- maintenir une surface du substrat (5) sur lequel le composant (6) doit être monté dans un plan à un premier angle par rapport au plan du miroir (2) ;
- placer le composant (6) en position d'alignement, la surface du composant à monter sur le substrat (5) se situant dans un plan à un second angle, égal au premier, mais dans la direction opposée à celui-ci, par rapport au plan du miroir (2), la ligne d'intersection de la surface du composant (6) et de la surface du substrat (5) avec le plan du miroir (2) étant coïncidente ;
- aligner mutuellement le composant (6) et le substrat (5) ; et
- placer le composant (6) en position de montage, la surface du composant à monter sur le substrat se situant sur la surface du substrat (5) sur lequel le composant doit être monté ;
- **caractérisé en ce qu'**il consiste à :
- déterminer une position de prise pour le composant (6), une surface du composant à monter sur le substrat (5) se trouvant dans le plan du miroir (2).

15. Procédé selon la revendication 14, comprenant une au moins des étapes consistant à :
- effectuer une translation du substrat (5) parallèlement à la surface du substrat ;
- effectuer une translation du composant (6) parallèlement à la surface du composant ; et une au moins des étapes consistant à :
- faire tourner le substrat (5) autour d'un axe de rotation perpendiculairement à la surface du substrat ; et
- effectuer une translation du composant (6) autour d'un axe de rotation perpendiculairement à la surface du composant.

16. Miroir (2) utilisé dans un dispositif ou un procédé selon l'une quelconque des revendications précédentes, comprenant un système de deux couches de substrat optiquement identiques (22, 24) entre lesquelles se situe le plan du miroir, et dans lequel les dimensions de la première couche (22) sont plus importantes, au moins dans une direction dans le plan du miroir, que les dimensions de la seconde couche (24).
